(19) **Europäisches Patentamt / European Patent Office / Office européen des brevets**

(11) **EP 3 106 887 B1**

(12) **FASCICULE DE BREVET EUROPEEN**

(45) Date de publication et mention
de la délivrance du brevet:
**08.03.2023 Bulletin 2023/10**

(21) Numéro de dépôt: **16171866.3**

(22) Date de dépôt: **30.05.2016**

(51) Classification Internationale des Brevets (IPC):
**G01R 19/04** *(2006.01)*

(52) Classification Coopérative des Brevets (CPC):
**G01R 31/52; G01R 19/04;** G01R 19/2506;
G01R 31/08

(54) **PROCEDE ET DISPOSITIF DE DETECTION D'UN DEFAUT DANS UN RESEAU ELECTRIQUE**

VERFAHREN UND VORRICHTUNG ZUR DETEKTION EINER STÖRUNG IN EINEM STROMNETZ

METHOD AND DEVICE FOR DETECTING A FAULT IN AN ELECTRICAL NETWORK

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.06.2015 FR 1555458**

(43) Date de publication de la demande:
**21.12.2016 Bulletin 2016/51**

(73) Titulaire: **Schneider Electric Industries SAS
92500 Rueil-Malmaison (FR)**

(72) Inventeurs:
• **VERNEAU, Guillaume
69660 Collonges au Mont d'Or (FR)**
• **BAUMES, Nathalie
01360 Bressolles (FR)**

(74) Mandataire: **Schneider Electric
Service Propriété Industrielle
35, rue Joseph Monier
CS 30323
92506 Rueil-Malmaison Cedex (FR)**

(56) Documents cités:
**EP-A1- 0 322 518      EP-A1- 2 910 958
US-A1- 2006 215 064      US-A1- 2006 215 064**

**Description**

**DOMAINE TECHNIQUE**

L'invention concerne un procédé de détection rapide d'un défaut, par exemple défaut à la terre ou défaut entre phases, dans un réseau électrique moyenne tension ou basse tension. Le réseau électrique peut être soit aérien soit souterrain. Ce procédé repose sur l'analyse de l'amplitude d'un signal représentatif du courant circulant dans le réseau. L'invention concerne également un dispositif de détection apte à mettre en oeuvre ce procédé.

**ETAT DE LA TECHNIQUE**

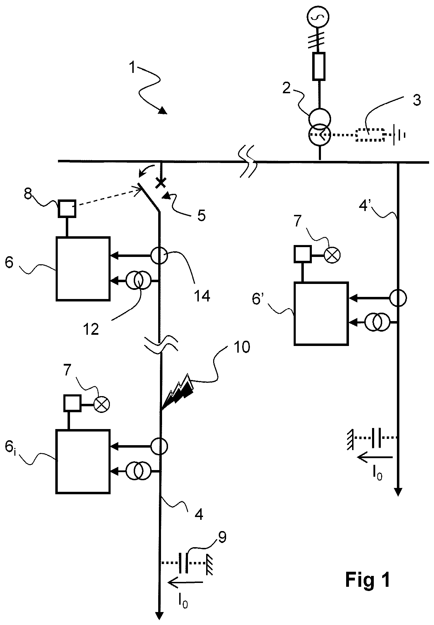

Les dispositifs de détection de défaut dans les réseaux électriques triphasés permettent de déclencher la protection des charges et/ou d'aider à la localisation desdits défauts. Par exemple, la figure 1 représente un schéma d'un réseau électrique 1 de distribution électrique moyenne tension qui comporte un transformateur 2 triphasé, dont le secondaire peut comporter un conducteur commun de neutre généralement connecté à la terre par une impédance 3, par exemple de type bobine de Petersen (dans le cas d'un réseau à neutre isolé, il n'existe pas de liaison physique entre le point neutre du réseau et la terre). Le secondaire est par ailleurs connecté à une ligne principale de distribution qui alimente des lignes de départ 4, 4', dont certaines peuvent comporter en tête un disjoncteur ou autre appareil de coupure 5 les protégeant.

Les lignes de départ 4, 4', composées de lignes aériennes et/ou de câbles souterrains, peuvent être sujettes à des défauts variés, qu'il est important de détecter et de localiser afin de pallier les problèmes générés : rupture d'alimentation, dégradation de la tenue des matériels d'isolation, etc. Un dispositif de détection de défaut 6i, 6', installé sur les lignes de départ 4' ou des tronçons de ligne 4, peut servir d'indicateur de passage de défaut, allumant par exemple un voyant lumineux 7. Par ailleurs, un dispositif 6 peut être associé ou intégré à un relais de protection 8 apte à commander l'ouverture des contacts du disjoncteur 5.

Parmi ces défauts, les plus fréquents sont les défauts monophasés, de type court-circuit, localisés hors du poste source, dans lesquels une phase est en contact avec la terre, ou la rupture d'un câble aérien en cas d'intempérie notamment. De plus, les défauts sont aussi parfois non permanents ou intermittents, en particulier sur les réseaux aériens : certains disparaissent naturellement avant la mise en fonctionnement des protections, d'autres sont éliminés par un cycle plus ou moins lent de ré-enclenchements.

Pour prendre les éventuelles précautions nécessaires ou mettre en oeuvre les dispositifs adaptés de caractérisation et localisation du défaut, la détection des défauts doit être rapide, de l'ordre de quelques millisecondes, voire moins dans le cas de défauts transitoires, et bien entendu fiable.

Dans la gestion des réseaux de distribution moyenne tension (MT) et basse tension (BT), il est classique de surveiller l'état du réseau, des équipements ou des processus industriels via la mesure de grandeurs électriques telles que les tensions et intensités, qui peuvent être monophasées ou triphasées selon le contexte. Cette surveillance permet de déterminer l'état du réseau ainsi que les conditions de mode opératoire (fonctionnement normal ou dysfonctionnement, lié par exemple à une surcharge de courant, un court-circuit ou une sous-tension d'alimentation,...).

De fait, on distingue deux possibilités pour réaliser cette surveillance :

- Surveillance hardware : via des capteurs dédiés (tension, courant), une chaine de mesure électronique permet de comparer les signaux électroniques représentatifs de la grandeur surveillée par rapport à un seuil prédéterminé, via un montage de type comparateur. L'avantage de ce principe est sa grande rapidité de traitement de la mesure : le résultat de la comparaison est obtenu en «quasi temps réel». L'inconvénient est que le seuil de comparaison est «figé» par le matériel, et n'offre pas de possibilité de réglages à l'utilisateur, sauf si la réalisation électronique prévoit autant de circuits de comparaison que de seuils envisageables ou si l'électronique inclut des composants variables (varistance, polyswitches...), qui sont généralement volumineux et chers. De plus, une telle solution ne permet pas de mettre en oeuvre des analyses, historiques ou algorithmes sophistiqués.
- Surveillance software : après un étage d'entrée (capteurs tension ou courant), les mesures sont échantillonnées, filtrées, converties en numérique, puis font l'objet d'un traitement du signal par un microprocesseur. Les caractéristiques (telles que l'amplitude, la fréquence, la phase angulaire) du signal électronique représentatif de la grandeur électrique surveillée sont déterminées par les méthodes classiques. Ainsi l'amplitude pourra être calculée par détermination de la valeur efficace du signal (ex : calcul RMS, pouvant se faire sur une fenêtre d'acquisition d'une ou plusieurs périodes réseau, cette fenêtre pouvant être fixe ou glissante) ou par l'utilisation de transformées mathématiques (ex : calcul de la composante directe, via l'utilisation de la matrice de Fortescue pour l'obtention des composantes symétriques en triphasé), ou encore par des phaseurs. L'avantage de cette approche réside notamment dans la souplesse de choix du seuil de comparaison par l'utilisateur, puisque le traitement est purement logiciel. L'inconvénient de l'approche réside dans son résultat «différé» : en effet, les méthodes de calcul citées nécessitent généralement l'acquisition des échantillons sur au moins une période réseau avant de pouvoir être exécutées. D'autre part, cette approche logicielle est forcément dépendante des performances du microprocesseur et de la fréquence d'échantillonnage utilisée : diminuer le nombre d'échantillons permet de gagner en temps de traitement au détriment de la précision du résultat, augmenter le nombre d'échantillons favorise la détermination de résultats précis au détriment de l'aspect réactivité.

Par ailleurs, le document EP0297418 décrit une méthode de détection de défaut de fréquence d'un réseau électrique. Dans cette méthode, on utilise plusieurs échantillons de mesure d'un signal à analyser pour calculer une fréquence estimée. Cependant, la méthode est récursive et en boucle fermée, c'est-à-dire que le calcul de la fréquence estimée à un instant t prend aussi en compte la fréquence estimée à l'instant précédent t-1 et sera également utilisé pour calculer la fréquence estimée à l'instant suivant t+1. Cette méthode peut donc être compliquée à mettre en oeuvre car il est nécessaire de connaître la fréquence estimée précédente pour calculer la nouvelle fréquence estimée. De plus, cette méthode étant récursive et en boucle fermée, elle présente un temps non négligeable pour converger vers la valeur exacte de l'amplitude calculée, ce qui diffère d'autant l'obtention d'un résultat précis. Qui plus est, toute interruption du processus, liée par exemple à l'ouverture du réseau, diffère une reprise «à la volée» du système lorsque le réseau est réalimenté : il faut de nouveau passer par cette phase de convergence qui génère une inertie. Il en est de même si une perturbation, par exemple de type électromagnétique, vient fausser la mesure d'un échantillon particulier.

Le document EP0322518 décrit une méthode de détection de défaut dans un relais de protection d'un réseau basée sur l'acquisition de trois échantillons du courant sinusoïdal circulant dans le réseau, à une fréquence d'échantillonnage proche de quatre fois la fréquence nominale. Cependant, le calcul de l'amplitude du courant dépend de la valeur de la fréquence d'échantillonnage, qui elle-même dépend de la fréquence réelle du courant, ce qui rend le calcul plus complexe et ne permet pas d'avoir les résultats escomptés, en particulier pour détecter des défauts transitoires.

Or, sur les réseaux électriques de distribution, en particulier sur les réseaux moyenne tension, la détection d'un dysfonctionnement doit pouvoir se faire très rapidement, afin de prendre les précautions nécessaires tant pour les équipements que pour les personnes. C'est notamment le cas des équipements de protection et de détection de défauts de type court-circuit (entre phases ou phase-terre), qui doivent réagir en quelques millisecondes de façon à pouvoir gérer ces défauts avec une très bonne réactivité, voire même pouvoir les anticiper. Cette détection se fait généralement par dépassement d'un seuil (haut ou bas) d'une variable représentative du courant électrique. Ainsi, certaines protections vont surveiller des surintensités, des surtensions ou sous-tensions, des dépassements de puissance active/réactive, etc...

Selon le type de régime de neutre du réseau, il est plus facile de voir un défaut sur une surintensité (neutre direct, neutre résistif) ou sur une surtension (neutre isolé) ou un mixte des deux (neutre compensé). Outre le type de défaut, on distingue aussi leur nature : défaut permanent (non éliminé par le cycle de réenclenchement du réseau) ou non permanent (éliminé avant la fin de ce cycle de réenclenchement).

Dans la suite du document, le terme amplitude A désigne la valeur absolue de l'amplitude crête d'un signal sinusoïdal Z, de type Z=A.sin(xt+y).

## EXPOSE DE L'INVENTION

Un des buts de l'invention est de proposer une méthode simple et rapide permettant de détecter un défaut d'un réseau électrique par l'analyse de l'amplitude d'un signal (tension ou courant) représentatif du courant circulant dans le réseau électrique.

L'invention vise à pallier des inconvénients des dispositifs et procédés de détection de défaut existants, et à optimiser la détection de défaut. Grâce à l'invention, il peut être possible d'anticiper un défaut suffisamment rapidement avant qu'il ne survienne réellement.

Pour cela, l'invention décrit un procédé de détection d'un défaut dans un réseau électrique parcouru par un courant alternatif, avec les caractéristiques décrites à la revendication 1.

L'invention concerne également un dispositif de détection d'un défaut capable de mettre en oeuvre un tel procédé de détection d'un défaut, comme la revendication 6 décrit.

L'invention concerne également un relais de protection destiné à la surveillance d'un réseau électrique ou tout appareil électrique interrupteur relié à un réseau électrique comportant un tel dispositif de détection de défaut du réseau électrique.

## BREVE DESCRIPTION DES FIGURES

D'autres avantages et caractéristiques ressortiront plus clairement de la description qui suit de modes particuliers de réalisation de l'invention, représentés dans les figures annexées suivantes :

- la figure 1, déjà décrite précédemment, représente un réseau électrique dans lequel des dispositifs de détection de défaut peuvent être utilisés,
- la figure 2 montre un exemple d'échantillonnage d'un signal représentatif du courant circulant dans le réseau électrique,
- la figure 3 représente de façon simplifiée le procédé de détection selon un mode de réalisation préféré de l'invention,
- les figures 4a à 4d illustrent un exemple avec quatre diagrammes montrant un signal S et des mesures de détection de défaut suivant le procédé de l'invention et d'autres méthodes,
- les figures 5a à 5d illustrent un autre exemple de comparaison entre le procédé de l'invention et d'autres méthodes.

## DESCRIPTION DETAILLEE D'UN MODE DE REALISATION

La figure 1 représente un schéma d'un réseau électrique 1 de distribution électrique moyenne tension qui comporte un transformateur 2 triphasé, dont le secondaire peut comporter un conducteur commun de neutre généralement connecté à la terre par une impédance 3. Le secondaire est par ailleurs connecté à une ligne principale de distribution qui alimente des lignes de départ 4, 4', dont certaines peuvent comporter en tête un disjoncteur ou autre dispositif de coupure 5 les protégeant.

Les lignes de départ 4, 4' sont composées de lignes aériennes et/ou de câbles souterrains et peuvent être sujettes à des défauts variés, qu'il est important de détecter et localiser afin de pallier les problèmes générés : rupture d'alimentation, dégradation de la tenue des matériels d'isolation, etc. Des dispositifs de détection de défaut 6, 6i, 6' installés sur la ligne de départ 4 ou des tronçons de ligne 4, servent à détecter des défauts. Une fois qu'un défaut est détecté, le dispositif de détection 6 peut comporter des moyens de signalisation de défaut, tel qu'un voyant d'alerte 7, des moyens de mémorisation d'informations relatives par exemple à la présence du défaut, au type de défaut et à la durée du défaut. Le dispositif de détection 6 peut aussi comporter des moyens de transmission des informations de défauts mémorisées vers un poste de conduite ou un dispositif de contrôle/commande du réseau électrique 1.

Un tel dispositif 6 peut aussi être intégré dans un appareil de surveillance de tout ou partie 4, 4' du réseau électrique 1, notamment dans un relais de protection 8 apte à commander l'ouverture des contacts du disjoncteur 5, ou peut être implanté directement dans un disjoncteur de façon à pouvoir ouvrir rapidement la ligne 4 du réseau électrique 1 en cas de défaut.

Parmi ces défauts, les plus fréquents sont les défauts monophasés, de type court-circuit, localisés hors du poste source, dans lesquels une phase est en contact avec la terre, ou la rupture d'un câble aérien en cas d'intempérie notamment. Or, par exemple entre les conducteurs de ligne 4 et la terre, peuvent apparaître des fortes valeurs de capacité 9 à l'origine de la circulation d'importants courants homopolaires $I_0$ en cas de défaut à la terre 10.

Le courant homopolaire $I_0$ est nul en l'absence de défaut. Par courant homopolaire $I_0$ (ou « *zéro séquence current* » selon la terminologie anglo-saxonne), on entend, à un éventuel facteur trois près, la sommation vectorielle des différents courants de phase, ou encore le courant correspondant à la résultante instantanée des courants de phase, parfois appelé courant résiduel, qui correspond éventuellement au courant de défaut à la terre (« *ground default current* » selon la terminologie anglo-saxonne) ou au courant de fuite. Il est à noter qu'il est possible de s'écarter de cette situation, avec notamment un courant/une tension homopolaire non nul, et le réseau peut comprendre un autre nombre de phases ; par ailleurs, le régime de neutre peut ne pas être compensé.

Pour détecter l'apparition d'un défaut dans un réseau électrique, il est connu de mesurer, à l'aide de capteurs, au moins un signal S représentatif du courant circulant dans la portion de réseau à tester. Ce signal représentatif S peut être par exemple la tension entre une des phases et la terre, la tension entre deux phases, le courant circulant dans une des phases ou le courant de l'ensemble des phases. En l'absence de défaut, le signal S est un signal sinusoïdal d'amplitude nominale $A_0$ et de fréquence nominale $f_0$, correspondant à la fréquence nominale du courant circulant dans le réseau électrique, par exemple 50 Hz ou 60 Hz.

Dans le mode de réalisation présenté, pour détecter un défaut 10 dans la ligne 4, le dispositif de détection 6 comporte un module d'acquisition comprenant un capteur permettant d'acquérir un signal analogique S représentatif du courant circulant dans la ligne 4, tels que par exemple un capteur de courant 14 ou un capteur de tension 12.

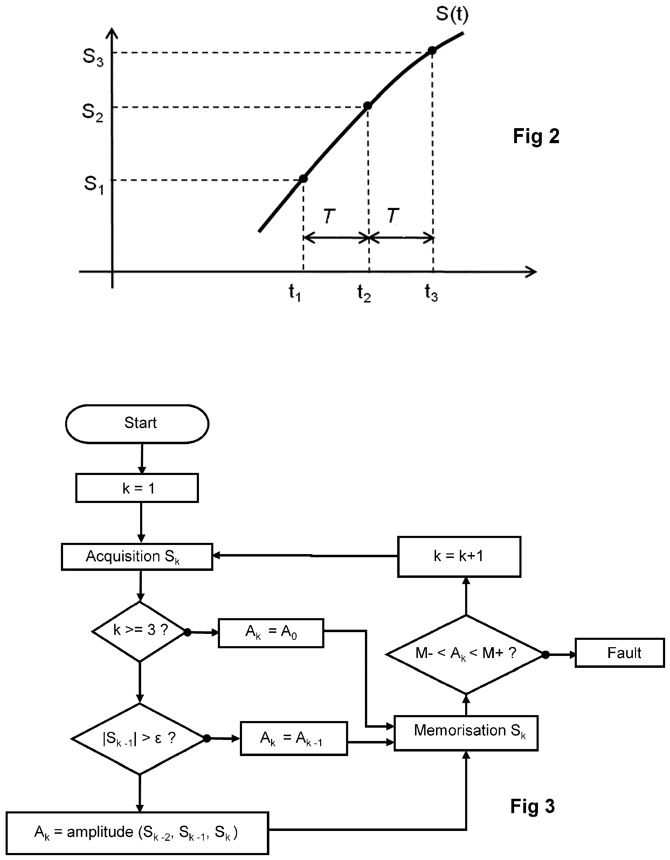

Le module d'acquisition est configuré pour obtenir au moins trois échantillons S1, S2, S3 du signal représentatif S, l'acquisition de chaque échantillon étant espacée d'un temps d'échantillonnage fixe T. C'est-à-dire que, comme indiqué en figure 2, si un premier échantillon S1 est mesuré à un temps t1, le deuxième échantillon sera mesuré à un temps t2 = t1 + T et le troisième échantillon sera mesuré à un temps t3 = t2 + T = t1 + 2T.

Pour les besoins de l'invention, le temps d'échantillonnage T doit correspondre à une fréquence d'échantillonnage F supérieure ou égale à trois fois la fréquence nominale $f_0$ du signal S, ce qui donne donc un temps d'échantillonnage T <= 6,66 msec pour une fréquence nominale de 50 Hz du réseau électrique 1.

Préférentiellement, de façon à accélérer la détection d'un défaut et à être en mesure de détecter des défauts transitoires extrêmement brefs, on choisit une fréquence d'échantillonnage F égale à 1800 Hz, c'est-à-dire à un temps d'échantillonnage T de 0,556 msec.

Le module d'acquisition comprend aussi des moyens de filtrage, tel qu'un filtre analogique des mesures réalisées par les capteurs 12 ou 14, ainsi que des moyens d'échantillonnage permettant d'obtenir le signal S échantillonné avec le temps d'échantillonnage T souhaité.

Le dispositif de détection comporte ensuite un module de calcul qui reçoit les échantillons successifs en provenance du module d'acquisition. Le module de calcul comporte des moyens de stockage pour mémoriser différents échantillons reçus du signal S. Ces moyens de stockage permettent de mémoriser au moins trois échantillons $S_1$, $S_2$, $S_3$ ou permettent de stocker des échantillons du signal S de manière glissante pendant une durée plus longue.

Selon l'invention, le module de calcul détermine l'amplitude A du signal S simplement à partir des valeurs $S_1$, $S_2$, $S_3$. Le signal sinusoïdal S est de la forme :

S(t) = A.sin(2.$\pi$.f.t + $\varphi$), dans lequel A représente l'amplitude, f la fréquence et $\varphi$ la phase angulaire. Dès lors, les 3 mesures successives S1, S2, S3 étant espacées de T, on peut écrire que :

$$S_1 = S(t_1) = S(t_2 - T) = A \times \sin\left(2 \cdot \pi \cdot f \cdot (t_2 - T) + \varphi\right)$$

$$S_2 = S(t_2) = A \times \sin\left(2 \cdot \pi \cdot f \cdot t_2 + \varphi\right)$$

$$S_3 = S(t_3) = S(t_2 + T) = A \times \sin\left(2 \cdot \pi \cdot f \cdot (t_2 + T) + \varphi\right)$$

Ce qui donne :

$$A = \sqrt{S_2^2 + \left(\frac{S_3 - S_1}{2 \cdot \sin(2 \cdot \pi \cdot f \cdot T)}\right)^2}$$

Moyennant un changement d'origine pour faire abstraction de la phase angulaire $\varphi$ et l'introduction de la pulsation angulaire $\omega = 2 \cdot \pi f$, on obtient :

$$S_1 = A \times \cos\left(\omega \cdot t_2 - 2 \cdot \pi \cdot f \cdot T\right)$$

$$S_2 = A \times \cos\left(\omega \cdot t_2\right)$$

$$S_3 = A \times \cos\left(\omega \cdot t_2 + 2 \cdot \pi \cdot f \cdot T\right)$$

Les propriétés trigonométriques de la fonction sinus permettent alors d'arriver à l'égalité suivante : $S_1 + S_3 = 2 \cdot S_2$

$$\cos\left(2 \cdot \pi \cdot f \cdot T\right) = \frac{S_1 + S_3}{2 \cdot S_2}$$

cos(2·$\pi$f·T) ou :      On obtient donc :

$$A = \sqrt{S_2^2 + \left(\frac{S_3 - S_1}{2 \cdot \sin\left(Arc\,\cos\left(\frac{S_1 + S_3}{2 \cdot S_2}\right)\right)}\right)^2} \quad \text{ou :} \quad A^2 = S_2^2 + \left(\frac{S_3 - S_1}{2 \cdot \sin\left(Arc\,\cos\left(\frac{S_1 + S_3}{2 \cdot S_2}\right)\right)}\right)^2$$

On montre ainsi que le calcul de l'amplitude A ne dépend que des trois valeurs successives mesurées S1, S2, S3, sans faire intervenir la fréquence du signal S ou le temps d'échantillonnage T, sans nécessiter de connaître des valeurs antérieures d'amplitude déjà calculées et sans avoir besoin de modélisation mathématique du système. Le procédé de calcul selon l'invention est donc avantageusement non récursif et non itératif. Le fait d'être indépendant du temps d'échantillonnage T simplifie largement calcul de l'amplitude A. De plus, si le temps d'échantillonnage dépend de la fréquence réelle du signal, il faut recalculer ce temps d'échantillonnage en fonction de cette fréquence réelle pour obtenir l'amplitude.

Ainsi, en supposant que le dispositif de détection mesure un quatrième échantillon S4 à un instant t4, égal à t2 + 2T, alors le module de calcul recalculera directement une nouvelle valeur d'amplitude A basé seulement sur les échantillons S2, S3, S4, sans utiliser l'échantillon S1 ou des valeurs d'amplitude déjà calculées.

Un des intérêts de ce procédé est donc de pouvoir très rapidement déterminer l'amplitude du signal S avec seulement 3 échantillons, contrairement à des approches qui nécessitent généralement au moins une période réseau pour estimer cette amplitude, et contrairement à des approches itératives qui nécessitent un temps non négligeable pour converger vers une valeur exacte et affiner le calcul de l'amplitude. Ainsi, par exemple après un redémarrage du réseau électrique faisant suite à une interruption du réseau, la reprise «à la volée» du processus se fait rapidement dès la mesure de trois échantillons, sans avoir à passer par une phase de convergence qui génère une inertie.

Pour déterminer l'amplitude A du signal S à partir de la formule ci-dessus de façon plus simple et rapide, le module de calcul peut privilégier une approche basée sur des développements limités pour les fonctions trigonométriques sinus et arccosinus, voire pour la fonction racine carrée, ce qui évite de requérir à des moyens de calcul trop importants. Selon la précision souhaitée, la fréquence d'échantillonnage choisie et les performances du microprocesseur intégré dans le module de calcul, le polynôme utilisé dans les développements limités sera pris à l'ordre 1 à 4. Par exemple, un développement limité à l'ordre 2 pour une fréquence d'échantillonnage de 1800 Hz est utilisé.

Le dispositif de détection 6 comporte ensuite un module de détermination de défaut qui est capable de déclencher un défaut si l'amplitude A calculée par le module de calcul est supérieure à un premier seuil prédéterminé M+, dit seuil haut (correspondant par exemple à une surintensité) ou si l'amplitude (A) calculée est inférieure à un second seuil prédéterminé M-, dit seuil bas (correspondant par exemple à une sous-tension, ou à un effet de type flicker,...). De préférence, les seuils sont centrés sur l'amplitude nominale $A_0$ du réseau.

Le seuil haut peut être fixé à partir de l'amplitude nominale $A_0$ à laquelle est ajoutée une première marge ou un premier pourcentage de l'amplitude nominale $A_0$, et le seuil bas peut être fixé à partir de l'amplitude nominale $A_0$ à laquelle est retirée une deuxième marge ou un deuxième pourcentage de l'amplitude nominale $A_0$. Par exemple, la norme NF EN50-160 considère un fonctionnement normal d'une tension Moyenne Tension à -10% / +10% de sa valeur nominale et d'une tension Basse Tension à -15% / +10% de sa valeur nominale; au-delà de ces bandes admissibles, il y a dysfonctionnement.

Avantageusement, le module de détermination de défaut peut aussi mémoriser le type et la durée d'un défaut, notamment pour pouvoir distinguer entre défaut permanent (non éliminé par le cycle de réenclenchement du réseau) et défaut transitoire (éliminé avant la fin de ce cycle de réenclenchement).

La figure 3 donne un organigramme simplifié du procédé décrit dans l'invention. Au démarrage d'une séquence de détection ou à la mise sous tension du dispositif de protection, aucun échantillon S n'est encore mémorisé et un indice k est initialisé par exemple à la valeur 1. Le procédé de protection prévoit alors d'effectuer une mesure $S_k$ du signal S qui est filtrée et numérisée.

Tant que l'indice k est inférieur à 3, ce qui signifie que l'on n'a pas encore acquis trois échantillons successifs, le procédé de détection n'est pas en mesure de détecter un défaut et donc force l'amplitude A calculée par exemple à la valeur nominale $A_0$ du signal S. Inversement, dès que k est supérieur ou égal à 3, alors l'amplitude $A_k$ est calculée comme étant une fonction des trois derniers échantillons successifs $S_{k-2}$, $S_{k-1}$, $S_k$, suivant l'algorithme expliqué précédemment.

Ensuite, le procédé de détection mémorise la valeur de l'échantillon $S_k$ dans les moyens de stockage du dispositif de détection et incrémente l'indice k à chaque temps d'échantillonnage T avant d'effectuer un nouveau cycle, avec la mesure d'un nouvel échantillon $S_k$ et un nouveau calcul de l'amplitude $A_k$. Ainsi, le calcul de l'amplitude est actualisé périodiquement à chaque temps d'échantillonnage T.

Puis, pour déterminer la présence d'un défaut, le procédé de détection passe par une étape de détermination dans laquelle on détecte si l'amplitude $A_k$ calculée est supérieure au premier seuil prédéterminé M+ ou si l'amplitude $A_k$ calculée est inférieure au second seuil prédéterminé M- afin de déterminer si l'amplitude $A_k$ est comprise dans une bande admissible.

Optionnellement, pour éviter de diviser par un nombre trop proche de 0 ce qui pourrait générer des erreurs de calcul, le procédé de détection prévoit d'effectuer un test sur la valeur de l'échantillon médian, c'est-à-dire $S_{k-1}$ si les trois échantillons sont $S_{k-2}$, $S_{k-1}$, $S_k$ (ou $S_2$ si les échantillons sont $S_1$, $S_2$, $S_3$), car la valeur de l'échantillon médian est utilisée au dénominateur de la formule proposée. Donc si la valeur absolue de l'échantillon médian $S_{k-1}$ est inférieure ou égale à un seuil minimum $\varepsilon$, alors l'amplitude $A_k$ n'est pas calculée mais reste égale à la valeur calculée précédente $A_{k-1}$. Par exemple, le seuil minimum $\varepsilon$ est de l'ordre de 0,2% de la valeur nominale $A_0$ du signal S.

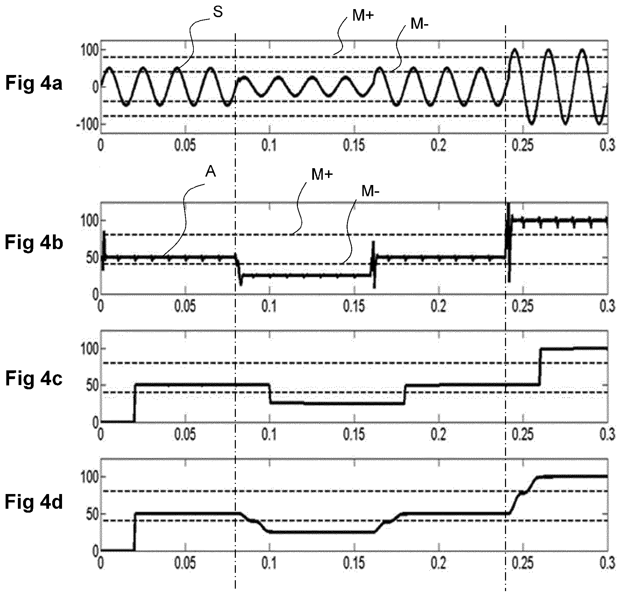

Le graphe de la figure 4a montre, sur une durée de 300 msec (échelle des abscisses en secondes), un premier exemple d'un signal sinusoïdal S à surveiller en fonction du temps, ainsi que la visualisation d'un seuil fixe haut M+ et d'un seuil fixe bas M-. Sur ce graphe, l'amplitude nominale $A_0$ du signal S est égale à 50, avec dans cet exemple M+ égal à 80 et M- égal à 40. Au début du graphe, on voit que l'amplitude du signal S est sensiblement égale à $A_0$, c'est-à-dire que le signal S oscille entre -50 et +50. Puis en milieu de graphe, l'amplitude du signal S diminue pour passer sous la valeur du seuil bas M- et, en fin de graphe, augmente pour passer au-dessus de la valeur du seul haut M+.

Les figures 4b à 4d comparent trois exemples de calcul de l'amplitude A du même signal S, faits à une même fréquence d'échantillonnage égale à 1800 Hz. Le graphe de la figure 4b montre le résultat du calcul de l'amplitude selon le procédé de détection de l'invention, avec un ordre 2 pour les développements limités des fonctions trigonométriques. Le graphe de la figure 4c montre un résultat utilisant une méthode basée sur un calcul RMS (Root Mean Square) à fenêtre fixe et celui de la figure 4d montre un résultat utilisant une méthode basée sur un calcul RMS à fenêtre glissante.

La figure 4b montre clairement que le procédé de l'invention donne un résultat plus rapide que les autres méthodes des figures 4c et 4d, aussi bien pour la détection d'un franchissement de seuil bas M- que pour la détection d'un franchissement de seuil haut M+.

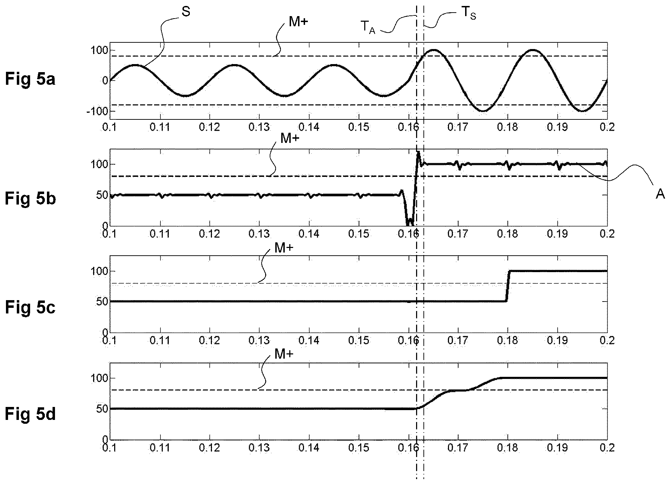

Les graphes des figures 5a à 5d détaillent un deuxième exemple qui illustre de façon plus précise que le procédé selon l'invention est aussi capable dans certains cas (en particulier suivant l'instant où l'amplitude du signal s'écarte de la sinusoïde nominale) de détecter un dépassement d'amplitude du signal S avant même que ce dépassement de seuil ne survienne réellement. Le procédé permet ainsi de prédire l'apparition d'un défaut, ce qui procure plusieurs avantages. En effet, cette information prédictive d'un dépassement d'amplitude est utilisée par divers équipements (par exemple relais de protection, disjoncteur en tête du départ, etc...). Elle peut aussi être envoyée à un système de supervision de façon prioritaire (type message GOOSE en IEC61850). On peut ainsi envisager : d'ouvrir préventivement le départ concerné et donc minimiser les dégradations matérielles et les risques au personnel; de limiter le courant de défaut à venir, par exemple si la mise à la terre du neutre du secondaire du transformateur est une bobine Petersen asservie en dynamique; de minimiser la durée d'interruption post défaut en préparant la reconfiguration du réseau après isolation de la section en défaut.

La figure 5a détaille sur une durée de 100 msec un signal sinusoïdal S à surveiller et un seuil fixe haut M+ égal à 80. Comme pour les figures 4b à 4d, les figures 5b à 5d comparent trois exemples de calcul de l'amplitude A du signal S de la figure 5a, faits à une même fréquence d'échantillonnage égale à 1800 Hz. La figure 5b montre le résultat du calcul de l'amplitude selon le procédé de détection de l'invention, avec un ordre 2 pour les développements limités des fonctions trigonométriques. La figure 5c montre un résultat utilisant une méthode basée sur un calcul RMS à fenêtre fixe et la figure 5d montre un résultat utilisant une méthode basée sur un calcul RMS à fenêtre glissante.

Sur la figure 5a, on voit que le franchissement du seuil haut M+ par le signal S a lieu à un instant noté $T_S$. Sur la figure 5b, on voit que l'amplitude A calculée selon le procédé de l'invention franchit ce seuil haut M+ à un instant noté $T_A$. Dans cet exemple, on note effectivement que l'instant $T_A$ est antérieur à l'instant $T_S$, d'environ 1,5 msec.

L'invention couvre également un appareil électrique comportant un tel dispositif de protection, de façon à pouvoir interrompre le réseau électrique en case de défaut. En effet, le dispositif de protection de l'invention peut être implanté dans différents types d'appareils, comme par exemple un relais de protection, un disjoncteur ou interrupteur ou un poste de supervision/téléconduite.

Dans un appareil, le dispositif de protection décrit dans l'invention peut aussi être éventuellement associé à un autre dispositif surveillant par exemple la fréquence du courant circulant dans le réseau électrique, de façon à ce que la prise de décision tienne compte de l'ensemble des résultats obtenus par les différents dispositifs.

Pour la surveillance d'un réseau électrique multiphases, par exemple triphasé, un appareil électrique comporte préférentiellement un dispositif de protection pour chacune des trois phases.

## Revendications

1. Procédé de détection d'un défaut dans un réseau électrique (1) parcouru par un courant alternatif de fréquence nominale ($f_0$), le procédé comprenant :

   - une étape d'acquisition de trois échantillons ($S_1$, $S_2$, $S_3$) d'un signal sinusoïdal (S) représentatif du courant circulant dans le réseau (1), l'acquisition de chaque échantillon étant espacée d'un temps d'échantillonnage fixe (T), le temps d'échantillonnage (T) correspondant à une fréquence d'échantillonnage supérieure ou égale à trois fois la fréquence nominale ($f_0$),
   - une étape de calcul d'une amplitude (A) du signal (S), le calcul de l'amplitude (A) étant uniquement fonction des trois échantillons ($S_1$, $S_2$, $S_3$) acquis,
   - une étape de détermination d'un défaut si l'amplitude (A) calculée est supérieure à un premier seuil prédéterminé (M+) ou si l'amplitude (A) calculée est inférieure à un second seuil prédéterminé (M-),

**caractérisé en ce que** l'amplitude (A) est calculée suivant une formule qui est indépendante du temps d'échantillonnage (T).

2. Procédé de détection d'un défaut selon la revendication 1 dans lequel le premier seuil est fixé par une amplitude nominale ($A_0$) du signal (S) à laquelle est ajoutée une première marge ou un premier pourcentage de l'amplitude nominale $A_0$, et le second seuil est fixé par l'amplitude nominale ($A_0$) du signal (S) à laquelle est retirée une seconde marge ou un deuxième pourcentage de l'amplitude nominale $A_0$.

3. Procédé de détection d'un défaut selon la revendication 1 dans lequel le temps d'échantillonnage (T) correspond à une fréquence d'échantillonnage étant égale à 1800 Hz.

4. Procédé de détection d'un défaut selon la revendication 1 dans lequel le calcul de l'amplitude (A) utilise la formule suivante :

$$A = \sqrt{S_2^2 + \left( \frac{S_3 - S_1}{2 \cdot \sin\left( Arc\ \cos\left( \frac{S_1 + S_3}{2 \cdot S_2} \right) \right)} \right)^2}$$

5. Procédé de détection d'un défaut selon la revendication 4, dans lequel les trois échantillons ($S_1$, $S_2$, $S_3$) comportent un échantillon médian (S2), **caractérisé en ce que** si la valeur de l'échantillon médian (S2) est inférieure à un seuil minimum, durant l'étape de calcul l'amplitude (A) reste égale à une valeur d'amplitude ($A_{k-1}$) calculée précédemment.

6. Dispositif de détection d'un défaut dans un réseau électrique (1) parcouru par un courant alternatif de fréquence nominale ($f_0$), le dispositif comprenant :

   - un module d'acquisition capable d'obtenir trois échantillons ($S_1$, $S_2$, $S_3$) d'un signal sinusoïdal (S) représentatif du courant circulant dans le réseau (1), l'acquisition de chaque échantillon étant espacée d'un temps d'échantillonnage fixe (T), le temps d'échantillonnage (T) correspondant à une fréquence d'échantillonnage supérieure ou égale à trois fois la fréquence nominale ($f_0$),
   - un module de calcul capable de calculer une amplitude (A) du signal (S), le calcul de l'amplitude (A) étant uniquement fonction des trois échantillons ($S_1$, $S_2$, $S_3$) acquis,
   - un module de détermination de défaut capable de déterminer un défaut si l'amplitude (A) calculée est supérieure à un premier seuil prédéterminé ou si l'amplitude (A) calculée est inférieure à un second seuil prédéterminé.

   **caractérisé en ce que** le calcul de l'amplitude (A) est effectué suivant une formule qui est indépendante du temps d'échantillonnage (T).

7. Dispositif de détection d'un défaut selon la revendication 6, **caractérisé en ce que** le module de calcul comporte des moyens de stockage des trois échantillons ($S_1$, $S_2$, $S_3$).

8. Relais de protection destiné à la surveillance d'un réseau électrique (1), **caractérisé en ce que** le relais de protection comporte un dispositif de détection de défaut selon la revendication 6.

9. Appareil électrique interrupteur raccordé à un réseau électrique (1), **caractérisé en ce que** l'appareil électrique comporte un dispositif de détection de défaut selon la revendication 6.

**Patentansprüche**

1. Verfahren zur Erkennung eines Fehlers in einem Stromnetz (1), das von einem Wechselstrom einer Nennfrequenz ($f_0$) durchflossen wird, wobei das Verfahren enthält:

   - einen Schritt der Erfassung von drei Tastproben ($S_1$, $S_2$, $S_3$) eines sinusförmigen Signals (S), das für den im Netz (1) fließenden Strom repräsentativ ist, wobei die Erfassung jeder Tastprobe um eine festgelegte Abtastzeit (T) beabstandet ist, wobei die Abtastzeit (T) einer Abtastfrequenz höher als das oder gleich dem Dreifachen der Nennfrequenz ($f_0$) entspricht,

- einen Schritt der Berechnung einer Amplitude (A) des Signals (S), wobei die Berechnung der Amplitude (A) nur von den drei erfassten Tastproben ($S_1$, $S_2$, $S_3$) abhängt,
- einen Schritt der Bestimmung eines Fehlers, wenn die berechnete Amplitude (A) höher als eine erste vorbestimmte Schwelle (M+) ist oder wenn die berechnete Amplitude (A) niedriger als eine zweite vorbestimmte Schwelle (M-) ist,

**dadurch gekennzeichnet, dass** die Amplitude (A) gemäß einer Formel berechnet wird, die von der Abtastzeit (T) unabhängig ist.

2. Verfahren zur Erkennung eines Fehlers nach Anspruch 1, wobei die erste Schwelle durch eine Nennamplitude ($A_0$) des Signals (S) festgelegt wird, der ein erster Rand oder ein erster Prozentsatz der Nennamplitude $A_0$ hinzugefügt wird, und die zweite Schwelle durch die Nennamplitude ($A_0$) des Signals (S) festgelegt wird, von der ein zweiter Rand oder ein zweiter Prozentsatz der Nennamplitude $A_0$ entfernt wird.

3. Verfahren zur Erkennung eines Fehlers nach Anspruch 1, wobei die Abtastzeit (T) einer Abtastfrequenz entspricht, die gleich 1800 Hz ist.

4. Verfahren zur Erkennung eines Fehlers nach Anspruch 1, wobei die Berechnung der Amplitude (A) die folgende Formel verwendet:

$$A = \sqrt{S_2^2 + \left( \frac{S_3 - S_1}{2.\sin\left(Arc\,cos\left(\frac{S_1 + S_3}{2 \cdot S_2}\right)\right)} \right)}$$

5. Verfahren zur Erkennung eines Fehlers nach Anspruch 4, wobei die drei Tastproben ($S_1$, $S_2$, $S_3$) eine mittlere Tastprobe ($S_2$) aufweisen, **dadurch gekennzeichnet, dass**, wenn der Wert der mittleren Tastprobe ($S_2$) niedriger ist als eine minimale Schwelle, während des Berechnungsschritts die Amplitude (A) gleich einem vorher berechneten Amplitudenwert ($A_{k-1}$) bleibt.

6. Vorrichtung zur Erkennung eines Fehlers in einem Stromnetz (1), das von einem Wechselstrom einer Nennfrequenz ($f_0$) durchflossen wird, wobei die Vorrichtung enthält:

- ein Erfassungsmodul, das fähig ist, drei Tastproben ($S_1$, $S_2$, $S_3$) eines sinusförmigen Signals (S) zu erhalten, das für den im Netz (1) fließenden Strom repräsentativ ist, wobei die Erfassung jeder Tastprobe um eine festgelegte Abtastzeit (T) beabstandet ist, wobei die Abtastzeit (T) einer Abtastfrequenz höher als das oder gleich dem Dreifachen der Nennfrequenz ($f_0$) entspricht,
- ein Rechenmodul, das fähig ist, eine Amplitude (A) des Signals (S) zu berechnen, wobei die Berechnung der Amplitude (A) nur von den drei erfassten Tastproben ($S_1$, $S_2$, $S_3$) abhängt,
- ein Fehlerbestimmungsmodul, das fähig ist, einen Fehler zu bestimmen, wenn die berechnete Amplitude (A) höher ist als eine erste vorbestimmte Schwelle oder wenn die berechnete Amplitude (A) niedriger ist als eine zweite vorbestimmte Schwelle,

**dadurch gekennzeichnet, dass** die Berechnung der Amplitude (A) gemäß einer Formel berechnet wird, die von der Abtastzeit (T) unabhängig ist.

7. Vorrichtung zur Erkennung eines Fehlers nach Anspruch 6, **dadurch gekennzeichnet, dass** das Rechenmodul Speichereinrichtungen der drei Tastproben ($S_1$, $S_2$, $S_3$) aufweist.

8. Schutzrelais, das zur Überwachung eines Stromnetzes (1) bestimmt ist, **dadurch gekennzeichnet, dass** das Schutzrelais eine Fehlererkennungsvorrichtung nach Anspruch 6 aufweist.

9. Elektrisches Schaltgerät, das an ein Stromnetz (1) angeschlossen ist, **dadurch gekennzeichnet, dass** das elektrische Gerät eine Fehlererkennungsvorrichtung nach Anspruch 6 aufweist.

**Claims**

1. Method for detecting a fault in an electrical network (1) through which an AC current of nominal frequency ($f_0$) flows, the method comprising:

   - a step of acquiring three samples ($S_1$, $S_2$, $S_3$) of a sinusoidal signal (S) that is representative of the current flowing in the network (1), the acquisition of each sample being spaced apart by a fixed sampling time (T), the sampling time (T) corresponding to a sampling frequency being more than or equal to three times the nominal frequency (f0);
   - a step of calculating an amplitude (A) of the signal (S), the calculation of the amplitude (A) depending solely on the three acquired samples ($S_1$, $S_2$, $S_3$);
   - a step of determining a fault if the calculated amplitude (A) is above a first predetermined threshold (M+) or if the calculated amplitude (A) is below a second predetermined threshold (M-),

   **characterized in that** the amplitude (A) is calculated according to a formula that is independent of the sampling time (T).

2. Method for detecting a fault according to Claim 1, in which the first threshold is set by a nominal amplitude ($A_0$) of the signal (S) to which a first margin or a first percentage of the nominal amplitude $A_0$ is added, and the second threshold is set by the nominal amplitude ($A_0$) of the signal (S) from which a second margin or a second percentage of the nominal amplitude $A_0$ is taken.

3. Method for detecting a fault according to Claim 1, in which the fixed sampling time (T) corresponds to a sampling frequency being equal to 1800 Hz.

4. Method for detecting a fault according to Claim 1, in which the calculation of the amplitude (A) uses the following formula:

$$A = \sqrt{S_2^2 + \left( \frac{S_3 - S_1}{2 \cdot \sin\left( Arc \cos\left( \frac{S_1 + S_3}{2 \cdot S_2} \right) \right)} \right)^2}$$

5. Method for detecting a fault according to Claim 4, in which the three samples (S1, S2, S3) comprise a median sample (S2), **characterized in that** when the value of the median sample (S2) is below a minimum threshold, during the step of calculating, the amplitude (A) remains equal to a preceding calculated value (Ak-1).

6. Device for detecting a fault in an electrical network (1) through which an AC current of nominal frequency ($f_0$) flows, the device comprising:

   - an acquisition module that is capable of obtaining three samples ($S_1$, $S_2$, $S_3$) of a sinusoidal signal (S) that is representative of the current flowing in the network (1), the acquisition of each sample being spaced apart by a fixed sampling time (T), the sampling time (T) corresponding to a sampling frequency being more than or equal to three times the nominal frequency (f0);
   - a calculation module that is capable of calculating an amplitude (A) of the signal (S), the calculation of the amplitude (A) depending solely on the three acquired samples (S1, S2, S3);
   - a fault determination module that is capable of determining a fault if the calculated amplitude (A) is above a first predetermined threshold or if the calculated amplitude (A) is below a second predetermined threshold,

   **characterized in that** the amplitude (A) is calculated according to a formula that is independent of the sampling time (T).

7. Device for detecting a fault according to Claim 6, **characterized in that** the calculation module comprises means for storing the three samples ($S_1$, $S_2$, $S_3$).

8. Protection relay for the purpose of monitoring an electrical network (1), **characterized in that** the protection relay comprises a device for detecting a fault according to Claim 6.

9. Electrical switch unit connected to an electrical network (1), **characterized in that** the electrical unit comprises a device for detecting a fault according to Claim 6.

Fig 1

**Fig 2**

**Fig 3**

Fig 4a

Fig 4b

Fig 4c

Fig 4d

Fig 5a

Fig 5b

Fig 5c

Fig 5d

**EP 3 106 887 B1**

## RÉFÉRENCES CITÉES DANS LA DESCRIPTION

### Documents brevets cités dans la description

- EP 0297418 A
- EP 0322518 A